# EUROPEAN PATENT APPLICATION

(11) **EP 4 607 584 A1**
(43) Date of publication of application: **27.08.2025**
(21) Application number: 24202567.4
(22) Date of filing: 25.09.2024
(51) Int. Cl.: H01L 23/31, H01L 23/36, H01L 23/373, H01L 25/07, H01L 23/00, H01L 23/538, H01L 23/051, H01L 23/053, H01L 23/24

(54) **SEMICONDUCTOR MODULE ARRANGEMENT**

(30) Priority: 23.02.2024 EP 24159389
(71) Applicant: Infineon Technologies AG, 85579 Neubiberg (DE)
(72) Inventor: MICHALSKI, Sebastian, 13347 Berlin (DE); ARENS, Andre, 59602 Rüthen (DE); SCHARF, Thomas, 93138 Lappersdorf (DE)
(74) Representative: Westphal, Mussgnug & Partner, Patentanwälte mbB

(57) **Abstract**

A semiconductor module arrangement comprises a substrate, a metal layer, and a plurality of semiconductor components arranged on the substrate, and between the metal layer and the substrate. Each semiconductor component of the plurality of semiconductor components comprises a semiconductor chip having a first electrode arranged on a first side of the semiconductor chip, and a second electrode arranged on a second side of the semiconductor chip opposite the first side, a first metallic layer attached to the first electrode of the semiconductor chip by means of an electrically conducting connection layer, a second metallic layer attached to the second electrode of the semiconductor chip by means of an electrically conducting connection layer, and a dielectrically insulating layer covering surfaces of the semiconductor chip, wherein surfaces of the first and second metallic layers that face away from the semiconductor chip are at least partially uncovered by the dielectrically insulating layer. Each semiconductor component of the plurality of semiconductor components is arranged on the substrate such that one of its first and second electrode faces towards and is electrically coupled to the substrate, and the respective other one of the first and second electrode faces away from the substrate, and the metal layer is coupled to the respective electrodes facing away from the substrate of the plurality of semiconductor components, thereby electrically coupling the respective electrodes to each other.

## Description

### TECHNICAL FIELD

The instant disclosure relates to a semiconductor module arrangement, in particular a semiconductor module arrangement comprising one or more semiconductor chips.

### BACKGROUND

Semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

A distance between neighboring controllable or non-controllable semiconductor elements is often comparably large due to thermal requirements, for example. Further, the overall costs of a semiconductor module may be high in order to meet all thermal, electrical and environmental requirements. Semiconductor module arrangements are generally required to provide a low-inductance design while, at the same time, having a high current carrying capability.

There is a need for a semiconductor module arrangement that is small in size and has increased thermal properties, a high current carrying capability as well as a low-inductance.

### SUMMARY

A semiconductor module arrangement includes a substrate, a metal layer, and a plurality of semiconductor components arranged on the substrate, and between the metal layer and the substrate. Each semiconductor component of the plurality of semiconductor components includes a semiconductor chip having a first electrode arranged on a first side of the semiconductor chip, and a second electrode arranged on a second side of the semiconductor chip opposite the first side, a first metallic layer attached to the first electrode of the semiconductor chip by means of an electrically conducting connection layer, a second metallic layer attached to the second electrode of the semiconductor chip by means of an electrically conducting connection layer, and a dielectrically insulating layer covering surfaces of the semiconductor chip, wherein surfaces of the first and second metallic layers that face away from the semiconductor chip are at least partially uncovered by the dielectrically insulating layer. Each semiconductor component of the plurality of semiconductor components is arranged on the substrate such that one of its first and second electrode faces towards and is electrically coupled to the substrate, and the respective other one of the first and second electrode faces away from the substrate, and the metal layer is coupled to the respective electrodes facing away from the substrate of the plurality of semiconductor components, thereby electrically coupling the respective electrodes to each other.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a semiconductor module arrangement.
Figure 2 is a cross-sectional view of a semiconductor element of a semiconductor module arrangement according to embodiments of the disclosure.
Figure 3 is a cross sectional view of a semiconductor module arrangement according to embodiments of the disclosure.
Figure 4 is a three-dimensional view of a semiconductor module arrangement according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable).

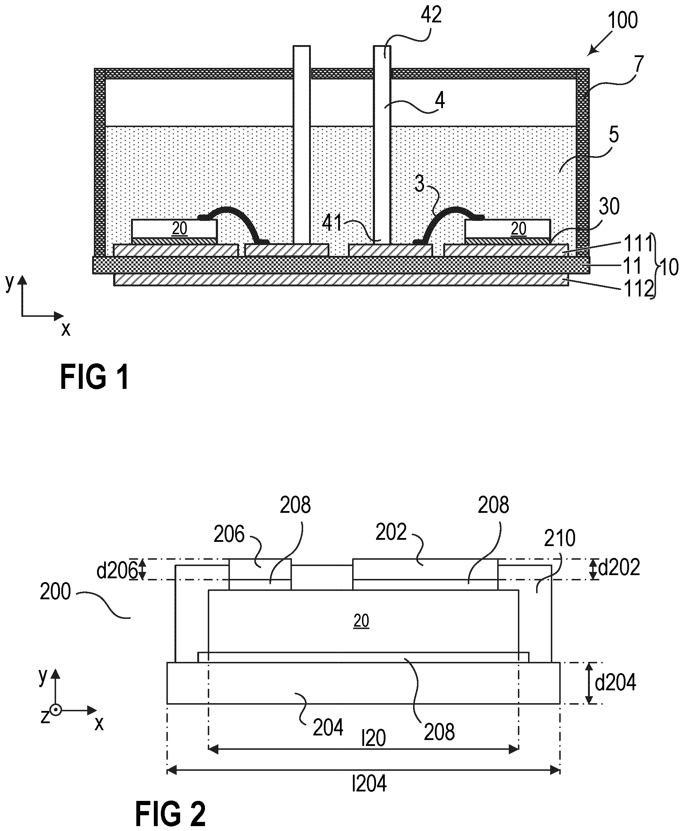

Referring to Figure 1, a cross-sectional view of a semiconductor module arrangement 100 is illustrated. The semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AIN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AIN, or BN and may have a diameter of between about 1µm and about 50µm.

The substrate 10 is arranged in a housing 7. In the example illustrated in Figure 1, the substrate 10 forms a base surface of the housing 7, while the housing 7 itself solely comprises sidewalls and a cover. This is, however, only an example. It is also possible that the housing 7 further comprises a base surface and the substrate 10 be arranged inside the housing 7. According to another example, the substrate 10 may be mounted on a base plate (not illustrated). In some semiconductor module arrangements 100, more than one substrate 10 is arranged on a single base plate. The base plate may form a base surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. Each semiconductor body 20 of the one or more semiconductor bodies 20 may be electrically and mechanically connected to the semiconductor substrate 10 by an electrically conductive connection layer 30. Such an electrically conductive connection layer may be a solder layer, a diffusion solder layer, a layer of an electrically conductive adhesive, or a layer of a sintered metal powder, e.g., a sintered silver powder, for example.

The semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. Each terminal element 4 of the terminal elements 4 may be electrically and mechanically connected to the substrate 10 by means of an electrically conductive connection layer (not specifically illustrated for the terminal elements 4). Such an electrically conductive connection layer generally may be a solder layer, a diffusion solder layer, a layer of an electrically conductive adhesive, or a layer of a sintered metal powder, e.g., a sintered silver powder, for example.

Conventional semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the semiconductor module 100, in particular inside the housing 7, from certain environmental conditions and mechanical damage.

The semiconductor bodies 20 arranged on the substrate 10 are usually semiconductor chips that are not separately packaged in any way. That is, they are so-called bare dies. Once the semiconductor arrangement is formed on the substrate 10, the final semiconductor module arrangement may be tested. It is, however, generally not possible to separately test each of the semiconductor chips before arranging them on the substrate 10. Bare-die semiconductor chips generally have to be handled carefully to avoid any damages thereto which might decrease the overall lifetime of the semiconductor module. When arranging the semiconductor chips on the substrate 10, thermal and electrical requirements have to be met. This often results in comparably large distances between neighboring semiconductor chips and, therefore, a comparably large size of the overall semiconductor module. In order to overcome these drawbacks, a semiconductor module arrangement according to embodiments of the disclosure comprises a plurality of pre-packaged semiconductor chips that are electrically coupled to each other via a metal layer, which will be described in further detail below.

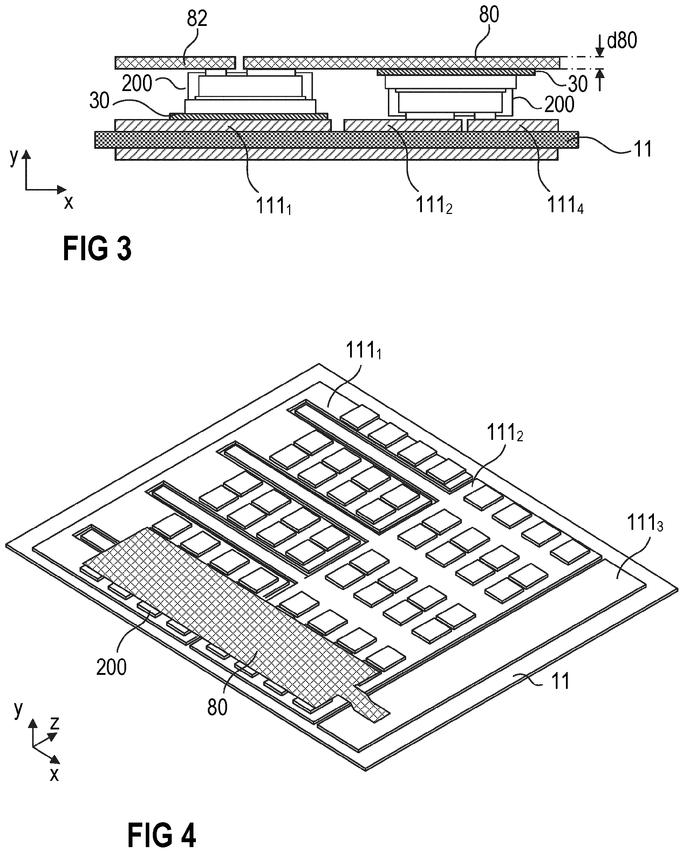

In particular, a semiconductor module arrangement according to embodiments of the disclosure comprises a substrate 10, a metal layer 80, and a plurality of semiconductor components 200 arranged on the substrate 10, and between the metal layer 80 and the substrate 10. Each semiconductor component 200 of the plurality of semiconductor components 200 comprises a semiconductor chip 20 having a first electrode arranged on a first side of the semiconductor chip 20, and a second electrode arranged on a second side of the semiconductor chip 20 opposite the first side. A first metallic layer 202 is attached to the first electrode of the semiconductor chip 20 by means of an electrically conducting connection layer 208, and a second metallic layer 204 is attached to the second electrode of the semiconductor chip 20 by means of an electrically conducting connection layer 208. A dielectrically insulating layer 210 covers surfaces of the semiconductor chip 20, wherein surfaces of the first and second metallic layers 202, 204 that face away from the semiconductor chip 20 are at least partially uncovered by the dielectrically insulating layer 210. Each semiconductor component 200 of the plurality of semiconductor components 200 is arranged on the substrate 10 such that one of its first and second electrode faces towards and is electrically coupled to the substrate 10, and the respective other one of the first and second electrode faces away from the substrate 10. The metal layer 80 is coupled to the respective electrodes of the plurality of semiconductor components 200 facing away from the substrate 10, thereby electrically coupling the respective electrodes to each other. The electrically conducting connection layers 208 may be solder layers, diffusion solder layers, layers of an electrically conductive adhesive, or layers of a sintered metal powder, for example. This is schematically illustrated in Figure 3 and will be described in further detail below.

The first and second metallic layers 202, 204 allow to electrically contact the first and second electrode, respectively, that are arranged in the package formed by the dielectrically insulating layer 210. The dielectrically insulating layer 210 may be formed by means of a rigid material such as, e.g., a rigid plastic or a ceramic material. The dielectrically insulating layer 210 may be formed in any suitable way, e.g., by means of molding techniques. According to some examples, the material forming the dielectrically insulating layer 210 may be configured to withstand high temperatures, e.g., temperatures of more than 100°C, or more than 200°C. In this way, local temperature stability of the semiconductor module arrangement may be increased.

Referring to Figure 2, an exemplary semiconductor component 200 as can be used in a semiconductor module arrangement according to embodiments of the disclosure is schematically illustrated. In this example, the semiconductor chip 20 further comprises a third electrode, and the semiconductor component 200 further comprises a third metallic layer 206 attached to the third electrode of the semiconductor chip 20 by means of an electrically conducting connection layer 208. A surface of the third metallic layer 206 that faces away from the semiconductor chip 20 is at least partially uncovered by the dielectrically insulating layer 210. In this way, the third electrode may be electrically contacted via the third metallic layer 206. The number of electrodes generally depends on the kind of component formed in the semiconductor chip 20. A diode, for example, generally only has two electrodes (first and second electrode), while an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other kind of transistor generally has at least three electrodes. The general principles similarly apply for semiconductor bodies 20 having two, three, or even more electrodes. One or more semiconductor components 200 may be arranged in a semiconductor module as has been described with respect to Figure 1 above. The semiconductor components 200 may replace the conventional semiconductor bodies (chips) 20, for example.

The first electrode of a semiconductor chip 20 may be arranged on a first side of the semiconductor chip 20 facing away from the substrate 10, and the second electrode of the semiconductor chip 20 may be arranged on a second side of the semiconductor chip 20 opposite the first side and facing towards the substrate 10, or vice versa. If the semiconductor chip 20 comprises a diode, the first electrode may be an anode electrode, and the second electrode may be a cathode electrode, for example. If the semiconductor chip comprises a transistor, the third electrode may be arranged on the same side as the first electrode. In this case, the first electrode may be a source or emitter electrode, the second electrode may be a drain or collector electrode, and the third electrode may be a gate or base electrode, for example.

The electrodes are generally formed on the semiconductor material of the semiconductor chip by means of comparably thin metallic layers. Such thin metallic layers may have thicknesses of up to 20µm, for example. Wherein a thickness of 20µm is generally considered comparably thick. A greater thickness of the electrodes, however, is usually required when they are contacted by comparably thick bonding wires or by means of a metal layer 80, for example. Forming a semiconductor chip 20 having comparably thick electrodes (e.g., 20µm or even more), however, is usually expensive. Attaching thick metallic layers 202, 204, 206 to the electrodes instead, may significantly reduce the overall costs of a semiconductor component 200.

The first, second and optional third metallic layers 202, 204, 206 may each comprise or consist of copper, or Wolfram or AlSiC or MgSiC or an electrically conductive material with a CTE (coefficient of thermal expansion) of 2 to 17ppm, for example. The first metallic layer 202 and the optional third metallic layer 206 may each have a thickness d202, d206 of between, e.g., 50µm and 300µm in a vertical direction y perpendicular to the first side of the semiconductor chip 20. The second metallic layer 204 may even have a thickness d204 of between 2.0mm and 3.0mm in the vertical direction y. Still referring to Figure 2, the semiconductor chip 20 has a first length l20 in a first horizontal direction x perpendicular to the vertical direction y, and a first width in a second horizontal direction z perpendicular to the first horizontal direction x and the vertical direction y. The second metallic layer 204 has a second length l204 in the first horizontal direction x and a second width in the second horizontal direction z. According to embodiments of the disclosure, a surface area of the second metallic layer 204 defined by the second length l204 and the second width (second surface area = second length * second width) is between 1 and 2 times a surface area of the semiconductor chip 20 defined by the first length l20 and the first width (first surface area = first length * first width).

In this way, the second metallic layer 204 may act as a heat spreader. That is, the heat that is generated by the semiconductor chip 20 during operation of the semiconductor module arrangement may be spread over the entire thickness d204 and large cross-sectional area of the second metallic layer 204 before being transferred further to the substrate 10. Due to the comparably large thickness d204 and the large cross-sectional area of the second metallic layer 204, the overall thermal resistance Rth of the semiconductor module arrangement can be significantly decreased (e.g., up to 30% or even more as compared to semiconductor module arrangements including bare die semiconductor chips 20).

The semiconductor components 200 which include a semiconductor chip 20 in a very simple package (formed by the dielectrically insulating layer 210) can be more easily handled as compared to bare dies. Even further, the semiconductor components 200 may be tested separately before arranging them on the substrate 10. That is, any faulty or damaged semiconductor components 200 may be sorted out before the semiconductor module arrangement is even assembled. This significantly increases the overall yield.

The semiconductor components 200, i.e. the metallic layers 202, 204, 206, may generally be electrically contacted in any suitable way, similar to conventional bare die components. Due to the fact that the packaged semiconductor components 200 are more robust than bare dies, they may even be electrically contacted in additional ways that may not be possible for the more fragile bare dies. As is schematically illustrated in Figure 3, a semiconductor component 200 may be attached and electrically coupled to a substrate 10 by means of an electrically conductive connection layer 30, similar to what has been described with respect to Figure 1 above. An electrically conductive connection layer 30 may be a solder layer, a diffusion solder layer, a layer of an electrically conductive adhesive, or a layer of a sintered metal powder, for example. A semiconductor component 200 may also be electrically connected to further sections of a first metallization layer 111 of a substrate 10 by means of electrical connections 3 such as, e.g., bonding wires, bonding ribbons, connection plates or conductor rails (not specifically illustrated in Figure 3).

Similar to what has been described with respect to the second metallic layer 204 above, a surface area of the first metallic layer 202 may be larger than a surface area of the first electrode of the semiconductor chip 20, and a surface area of the optional third metallic layer 206 may be larger than a surface area of the third electrode of the semiconductor chip 20. In this way, a larger surface area as compared to the bare die semiconductor chips 20 is available for attaching electrical connections 3 or terminal elements 4 thereto, for example.

According to embodiments of the disclosure, a plurality of semiconductor components 200 is sandwiched between a substrate 10 and a metal layer 80. In some embodiments, each semiconductor component 200 of the plurality of semiconductor components 200 may be arranged on the substrate 10 such that its second electrode faces towards the substrate 10, and its first electrode faces away from the substrate 10 and towards the metal layer 80 ("regular arrangement"). The first electrodes of the semiconductor components 200 in this example are attached to the metal layer 80, and the optional third electrodes may be attached to an additional metal layer 82, or may be electrically coupled to a respective section of the first metallization layer 111 by means of bonding wires or bonding ribbons, for example. Alternatively, each semiconductor component 200 of the plurality of semiconductor components 200 may be arranged on the substrate 10 such that its first electrode faces towards the substrate 10, and its second electrode faces away from the substrate 10 and towards the metal layer 80 ("upside-down arrangement"). The first and the optional third electrodes in this example are attached to respective sections of a first metallization layer 111 of the substrate 10 by means of an electrically conductive connection layer. The second electrodes are attached to the metal layer 80.

It is, however, also possible that a first subset of the plurality of semiconductor components 200 is arranged on the substrate 10 such that the second electrodes of the semiconductor components 200 of the first subset face towards the substrate 10, and the first electrodes face away from the substrate 10 and towards the metal layer 80 ("regular arrangement"), and a second subset of the plurality of semiconductor components 200 is arranged on the substrate 10 such that the first electrodes of the semiconductor components 200 of the first subset face towards the substrate 10, and the second electrodes face away from the substrate 10 and towards the metal layer 80 ("upside-down arrangement").

In the example illustrated in Figure 3, a first semiconductor component 200 (left side) and a second semiconductor component 200 (right side) are schematically illustrated. The second electrode of the first semiconductor component 200 faces towards and is electrically coupled to the substrate 10 (regular arrangement), and the first electrode of the second semiconductor component 200 faces towards and is electrically coupled to the substrate 10 (upside-down arrangement). The first electrode of the first semiconductor component 200 and the second electrode of the second semiconductor component 200 face away from the substrate 10 and are electrically coupled to the metal layer 80.

The substrate 10 comprises a dielectric insulation layer 11 and a first metallization layer 111 attached to the dielectric insulation layer 11, and the first and second semiconductor components 200 are arranged on a surface of the first metallization layer 111 that faces away from the dielectric insulation layer 11. The dielectric insulation layer 11 may be a ceramic layer, similar to what has been described with respect to Figure 1 above. The first metallization layer 111 in this example comprises a first section 111₁ and a second section 111₂ that is separate and distinct from the first section 111₁. At least a first subset of the semiconductor components 200 (i.e. the first semiconductor component 200) is arranged on the first section 111₁ such that the second electrode of each semiconductor component 200 of at least the first subset is arranged on and electrically coupled to the first section 111₁. The metal layer 80 is coupled to the first electrode of each semiconductor component 200 of the first subset of the plurality of semiconductor components 200.

In the example illustrated in Figure 3, the plurality of semiconductor components 200 further comprises a second subset of semiconductor components 200 (i.e. the second semiconductor component 200). The second subset of the semiconductor components 200 is arranged on the second section 111₂ such that the first electrode of each semiconductor component 200 of the second subset of semiconductor components 200 is arranged on and electrically coupled to the second section 111₂, and the metal layer 80 is coupled to the second electrode of each semiconductor component 200 of the second subset of semiconductor components 200.

In the example illustrated in Figure 3, each of the first and second semiconductor component 200 further comprises a third electrode. The third electrode, however, is only optional, as has been described above. The (optional) third electrode of the first semiconductor component 200 may be electrically contacted by means of an additional metal layer 82, for example. Alternatively, the (optional) third electrode of the first semiconductor component 200 may be electrically contacted in any other suitable way, e.g., by means of bonding wires or ribbons. The third electrode of the second semiconductor component 200, which faces towards the substrate 10, may be arranged on and electrically coupled to an additional section 111₄ of the first metallization layer 111.

Figure 4 schematically illustrates a three-dimensional view of a semiconductor module arrangement according to embodiments of the disclosure. The plurality of semiconductor components 200 in this example comprises 16 semiconductor components 200 which, however, are only partly visible below the metal layer 80. The plurality of semiconductor components 200, however, may include any number of semiconductor components. That is, the plurality of semiconductor components 200 may include two or more semiconductor components 200. Additional semiconductor components 20 may also be arranged on the substrate 10 which, however, are not arranged between the metal layer 80 and the substrate 10. Further semiconductor components 200 may be contacted in any suitable way, e.g., by means of additional metal layers (not specifically illustrated in Figure 4). In the example illustrated in Figure 4, the semiconductor components 200 only comprise a first electrode and a second electrode, but no additional third electrode. As described above, however, the general principles apply irrespective of whether the semiconductor components 200 comprise two or three or even more electrodes.

The first section 111₁ of the first metallization layer 111 may form or may be coupled to a first node (e.g., first supply node DC+) which is configured to be operatively connected to a first electrical potential, and the second section 111₂ of the first metallization layer 111 may form or may be electrically coupled to a second node (e.g., second supply node DC-) which is configured to be operatively connected to a second electrical potential. The metal layer 80 may form or may be coupled to a third node (e.g., output node AC). The semiconductor components may form or may be part of a half-bridge arrangement, to name just one of several possible examples.

By electrically coupling a plurality of semiconductor components 200 by means of the metal layer 80 which is arranged distant from the substrate 10, less space is needed on the substrate 10 itself. In particular, no additional section of the first metallization layer 111 is required to form or to be electrically coupled to the third node. The overall arrangement has a comparably low inductance, which is generally desirable. The overall costs of the semiconductor arrangement are also reduced as compared to conventional semiconductor module arrangements. This is, because no separate bonding connections need to be formed for the individual semiconductor components 200.

The metal layer 80 may be a comparably simple component, and electrically coupling the metal layer 80 to the respective electrodes of the plurality of semiconductor components is generally less complex as, for example, electrically contacting the respective electrodes to respective sections of the first metallization layer 111 by means of, e.g., bonding wires or bonding ribbons. The metal layer 80 may be electrically coupled to the respective electrodes of the plurality of semiconductor components 200 by means of sinter layers, solder layers, welded layers, electrically conducting adhesive layers, or diffusion solder layers, for example. It is, however, generally even possible that the metal layer 80 is solely pressed onto the respective electrodes of the plurality of semiconductor components, without forming a permanent connection between the metal layer 80 and the respective electrodes.

According to embodiments of the disclosure, the metal layer 80 may have a thickness d80 of between 18µm and 2mm. According to some examples, the metal layer 80 may be attached to an electrically insulating layer (not specifically illustrated), and may have a thickness d80 of between 18µm and 100µm. The metal layer 80 and the electrically insulating layer may form or may be part of a flexible printed-circuit board, for example.

According to further embodiments of the disclosure, the metal layer 80 may be implemented as a metal clip, having a thickness d80 of between 50µm and 2mm. That is, the metal layer 80 may be a separate component that is not part of a printed circuit board, a substrate, or anything similar. This, generally requires a somewhat greater thickness d80 as compared to metallization layers of flexible printed-circuit boards. The metal layer 80 may have a comparably large and flat section which extends above the plurality of semiconductor components 200, similar to what is schematically illustrated in Figure 4. In this example, the metal layer 80 has an essentially rectangular shape. This, however, is only an example. A metal clip, generally, may have any suitable shape. That is, the contour of the metal layer 80 may not be regular, but irregular instead. The metal layer 80 being essentially flat is also only one example. It is generally also possible that the metal layer 80 has bent portions. That is, different sections of the metal layer 80 may be arranged in different planes and may be connected to each other by means of vertical or diagonal sections, for example. For example, the metal layer 80 may comprise sections forming connection areas that are connected to the respective electrodes of the plurality of semiconductor components 200. Such connection areas may be connected to each other by means of one or more further sections of the metal layer 80, wherein the one or more further sections may be arranged further away from the substrate 10 than the connection areas.

As mentioned above, the metal layer 80 may be somewhat thinner when it is part of a flexible printed circuit board, for example, and may be somewhat thicker when the metal layer 80 is a separate component such as, e.g., a metal clip. Generally, however, the thickness d80 of the metal layer 80 also depends on a required current carrying capability. For high current carrying capabilities, generally a larger cross-sectional area of the metal layer 80, and therefore, a greater thickness d80 is required.

According to embodiments of the disclosure, the metal layer 80 may consist of copper, a copper alloy, aluminum or an aluminum alloy, for example. Other materials, however, may be equally suitable. The metal layer 80 may be covered by a coating layer, the coating layer consisting of or comprising at least one of nickel, silver, gold, palladium, and phosphor. Such a thin coating layer may increase the solderability of the metal layer 80, for example.

The metal layer 80 may be electrically coupled to a third section 111₃ of the substrate 10 that is separate and distinct from the first section 111₁ and the second section 111₂, similar to what is schematically illustrated in Figure 4. The third section 111₃ similar to the first and second sections 111₁, 111₂, may be electrically contacted by means of terminal elements, bus bars, or conductor rails, for example, similar to what has been described with respect to the terminal elements 4 in Figure 1 above. This, however, is only one example. According to further examples, the metal layer 80 may be directly contacted in any suitable way. That is, the metal layer 80 does not necessarily have to be electrically coupled to the first metallization layer 111 of the substrate 10 in any way.

In the figures, a first subset of the plurality of semiconductor components 200 is arranged on a first section 111₁ of the first metallization layer 111, and a second subset of the plurality of semiconductor components 200 is arranged on a second section 111₂ of the first metallization layer 111. This, however, is only an example. It is generally also possible that all semiconductor components 200 of the plurality of semiconductor components 200 are arranged on the same section of the first metallization layer 111. It is even possible that the plurality of semiconductor components 200 comprises more than two subsets which are arranged on more than two different sections of the first metallization layer 111. If, for example, the plurality of semiconductor components 200 form a half-bridge arrangement, some semiconductor components 200 (e.g., semiconductor components 200 forming high-side switches) may be arranged on a first section 111₁ of the first metallization layer 111, and other semiconductor components 200 (e.g., semiconductor components forming low-side switches) may be arranged on a second section 111₂ of the first metallization layer 111. According to another example, the plurality of semiconductor components 200 may only form a part of a semiconductor arrangement. For example, the plurality of semiconductor components 200 may provide only the high-side switches, or only the low-side switches of a half bridge. In this case, all semiconductor components 200 of the plurality of semiconductor components may be arranged on the same section of the first metallization layer 111. That is, it generally depends on a potential the respective electrodes of the semiconductor components 200 are to be coupled to, whether the semiconductor components 200 of the plurality of semiconductor components 200 are arranged on the same or on different sections of the first metallization layer 111.

A substrate 10 with the one or more semiconductor components 200 arranged thereon may finally be arranged in or form a base surface of a housing 7, similarly to what has been described with respect to Figure 1 above. The housing 7 may be at least partly filled with a casting compound 5, similar to what has been described with respect to Figure 1 above.

## Claims

1. A semiconductor module arrangement comprises:
a substrate (10);
a metal layer (80); and
a plurality of semiconductor components (200) arranged on the substrate (10), and between the metal layer (80) and the substrate (10); wherein
each semiconductor component (200) of the plurality of semiconductor components (200) comprises:
a semiconductor chip (20) having a first electrode arranged on a first side of the semiconductor chip (20), and a second electrode arranged on a second side of the semiconductor chip (20) opposite the first side,
a first metallic layer (202) attached to the first electrode of the semiconductor chip (20) by means of an electrically conducting connection layer (208),
a second metallic layer (204) attached to the second electrode of the semiconductor chip (20) by means of an electrically conducting connection layer (208), and
a dielectrically insulating layer (210) covering surfaces of the semiconductor chip (20), wherein surfaces of the first and second metallic layers (202, 204) that face away from the semiconductor chip (20) are at least partially uncovered by the dielectrically insulating layer (210), and wherein
each semiconductor component (200) of the plurality of semiconductor components (200) is arranged on the substrate (10) such that one of its first and second electrode faces towards and is electrically coupled to the substrate (10), and the respective other one of the first and second electrode faces away from the substrate (10), and
the metal layer (80) is coupled to the respective electrodes facing away from the substrate (10) of the plurality of semiconductor components (200), thereby electrically coupling the respective electrodes to each other.

2. The semiconductor module arrangement of claim 1, wherein the substrate (10) comprises a dielectric insulation layer (11) and a first metallization layer (111) attached to the dielectric insulation layer (11), and wherein the plurality of semiconductor components (200) is arranged on a surface of the first metallization layer (111) that faces away from the dielectric insulation layer (11).

3. The semiconductor module arrangement of claim 2, wherein the dielectric insulation layer (11) is a ceramic layer or an organic layer.

4. The semiconductor module arrangement of claim 2 or 3, wherein
the first metallization layer (111) comprises a first section (111₁) and a second section (111₂) that is separate and distinct from the first section (111₁),
at least a first subset of the plurality of semiconductor components (200) is arranged on the first section (111₁) such that the second electrode of each semiconductor component (200) of at least the first subset faces towards the substrate (10), and the metal layer (80) is coupled to the first electrode of each semiconductor component (200) of at least the first subset of the plurality of semiconductor components (200).

5. The semiconductor module arrangement of claim 4, wherein
the plurality of semiconductor components (200) further comprises a second subset of semiconductor components (200), and
the second subset of the plurality of semiconductor components (200) is arranged on the second section (111₂) such that the first electrode of each semiconductor component (200) of the second subset of semiconductor components (200) faces towards the substrate (10), and the metal layer (80) is coupled to the second electrode of each semiconductor component (200) of the second subset of semiconductor components (200).

6. The semiconductor module arrangement of claim 4 or 5, wherein the metal layer (80) is further electrically coupled to a third section (111₃) of the substrate (10) that is separate and distinct from the first section (111₁) and the second section (111₂).

7. The semiconductor module arrangement of any of the preceding claims, wherein the metal layer (80) is electrically coupled to the respective electrodes of the plurality of semiconductor components (200) by means of sinter layers, solder layers, welded layers, electrically conducting adhesive layers, or diffusion solder layers.

8. The semiconductor module arrangement of any of the preceding claims, wherein the metal layer (80) has a thickness of between 18µm and 2mm.

9. The semiconductor module arrangement of claim 8, wherein the metal layer (80) is attached to an electrically insulating layer, and has a thickness of between 18µm and 100µm, the metal layer (80) and the electrically insulating layer forming or being part of a flexible printed-circuit board.

10. The semiconductor module arrangement of claim 8, wherein the metal layer (80) is implemented as a metal clip, having a thickness of between 50µm and 2mm.

11. The semiconductor module arrangement of any of the preceding claims, wherein the metal layer (80) consists of copper, a copper alloy, aluminum or an aluminum alloy.

12. The semiconductor module arrangement of any of the preceding claims, wherein the metal layer (80) is covered by a coating layer, the coating layer consisting of or comprising at least one of nickel, silver, gold, palladium, tin, and phosphor.

13. The semiconductor module arrangement of any of the preceding claims, wherein the semiconductor chip (20) of each semiconductor component (200) of the plurality of semiconductor components (200) further comprises a third electrode, and the respective semiconductor component (200) further comprises a third metallic layer (206) attached to the third electrode of the semiconductor chip (20) by means of an electrically conducting connection layer (208), wherein a surface of the third metallic layer (206) that faces away from the semiconductor chip (20) is at least partially uncovered by the dielectrically insulating layer (210).

14. The semiconductor module arrangement of claim 13, wherein the third electrode is arranged on the first side of the semiconductor chip (20).

15. The semiconductor module arrangement of any of the preceding claims, wherein each of the plurality of semiconductor components (200) is attached and electrically coupled to the substrate (10) by means of an electrically conductive connection layer (30).

## Amended claims

### Amended claims in accordance with Rule 137(2) EPC.

1. A semiconductor module arrangement comprises:
a substrate (10);
a metal layer (80); and
a plurality of semiconductor components (200) arranged on the substrate (10), and between the metal layer (80) and the substrate (10); wherein
each semiconductor component (200) of the plurality of semiconductor components (200) comprises:
a semiconductor chip (20) having a first electrode arranged on a first side of the semiconductor chip (20), and a second electrode arranged on a second side of the semiconductor chip (20) opposite the first side,
a first metallic layer (202) attached to the first electrode of the semiconductor chip (20) by means of an electrically conducting connection layer (208),
a second metallic layer (204) attached to the second electrode of the semiconductor chip (20) by means of an electrically conducting connection layer (208), and
a dielectrically insulating layer (210) covering surfaces of the semiconductor chip (20), wherein surfaces of the first and second metallic layers (202, 204) that face away from the semiconductor chip (20) are at least partially uncovered by the dielectrically insulating layer (210), and wherein
each semiconductor component (200) of the plurality of semiconductor components (200) is arranged on the substrate (10) such that one of its first and second electrode faces towards and is electrically coupled to the substrate (10), and the respective other one of the first and second electrode faces away from the substrate (10),
the metal layer (80) is coupled to the respective electrodes facing away from the substrate (10) of the plurality of semiconductor components (200), thereby electrically coupling the respective electrodes to each other, and
either the metal layer (80) is attached to an electrically insulating layer, and has a thickness of between 18µm and 100µm, the metal layer (80) and the electrically insulating layer forming or being part of a flexible printed-circuit board, or
the metal layer (80) is implemented as a metal clip, having a thickness of between 50µm and 2mm.

2. The semiconductor module arrangement of claim 1, wherein the substrate (10) comprises a dielectric insulation layer (11) and a first metallization layer (111) attached to the dielectric insulation layer (11), and wherein the plurality of semiconductor components (200) is arranged on a surface of the first metallization layer (111) that faces away from the dielectric insulation layer (11).

3. The semiconductor module arrangement of claim 2, wherein the dielectric insulation layer (11) is a ceramic layer or an organic layer.

4. The semiconductor module arrangement of claim 2 or 3, wherein
the first metallization layer (111) comprises a first section (111₁) and a second section (111₂) that is separate and distinct from the first section (111₁),
at least a first subset of the plurality of semiconductor components (200) is arranged on the first section (111₁) such that the second electrode of each semiconductor component (200) of at least the first subset faces towards the substrate (10), and the metal layer (80) is coupled to the first electrode of each semiconductor component (200) of at least the first subset of the plurality of semiconductor components (200).

5. The semiconductor module arrangement of claim 4, wherein
the plurality of semiconductor components (200) further comprises a second subset of semiconductor components (200), and
the second subset of the plurality of semiconductor components (200) is arranged on the second section (111₂) such that the first electrode of each semiconductor component (200) of the second subset of semiconductor components (200) faces towards the substrate (10), and the metal layer (80) is coupled to the second electrode of each semiconductor component (200) of the second subset of semiconductor components (200).

6. The semiconductor module arrangement of claim 4 or 5, wherein the metal layer (80) is further electrically coupled to a third section (111₃) of the substrate (10) that is separate and distinct from the first section (111₁) and the second section (111₂).

7. The semiconductor module arrangement of any of the preceding claims, wherein the metal layer (80) is electrically coupled to the respective electrodes of the plurality of semiconductor components (200) by means of sinter layers, solder layers, welded layers, electrically conducting adhesive layers, or diffusion solder layers.

8. The semiconductor module arrangement of any of the preceding claims, wherein the metal layer (80) consists of copper, a copper alloy, aluminum or an aluminum alloy.

9. The semiconductor module arrangement of any of the preceding claims, wherein the metal layer (80) is covered by a coating layer, the coating layer consisting of or comprising at least one of nickel, silver, gold, palladium, tin, and phosphor.

10. The semiconductor module arrangement of any of the preceding claims, wherein the semiconductor chip (20) of each semiconductor component (200) of the plurality of semiconductor components (200) further comprises a third electrode, and the respective semiconductor component (200) further comprises a third metallic layer (206) attached to the third electrode of the semiconductor chip (20) by means of an electrically conducting connection layer (208), wherein a surface of the third metallic layer (206) that faces away from the semiconductor chip (20) is at least partially uncovered by the dielectrically insulating layer (210).

11. The semiconductor module arrangement of claim 10, wherein the third electrode is arranged on the first side of the semiconductor chip (20).

12. The semiconductor module arrangement of any of the preceding claims, wherein each of the plurality of semiconductor components (200) is attached and electrically coupled to the substrate (10) by means of an electrically conductive connection layer (30).
